# EUROPÄISCHE PATENTANMELDUNG

(11) **EP 1 630 252 A1**
(43) Veröffentlichungstag der Anmeldung: **01.03.2006**
(21) Anmeldenummer: 04090330.4
(22) Anmeldetag: 27.08.2004
(51) Int. Cl.: C23C 18/18, C23C 18/48, C23C 18/16

(54) **Verfahren zur beschichtung von Substraten enthaltend Antimonverbindungen mit Zinn und Zinnlegierungen**

(71) Anmelder: ATOTECH Deutschland GmbH, 10553 Berlin (DE)
(72) Erfinder: Lowinski, Christian, 16562 Bergfelde (DE); Schreier, Hans-Jürgen, 16727 Velten (DE); Steinberger, Gerhard, 13189 Berlin (DE); Nauman, Jana, 12157 Berlin (DE)

(57) **Zusammenfassung**

Die vorliegende Erfindung betrifft ein Verfahren zur Abscheidung von Zinn- oder Zinnlegierungsschichten auf Substraten, die als Flammschutzmittel und zur Verbesserung der Stanzbarkeit Antimonverbindungen enthalten dadurch gekennzeichnet, dass die Antimonverbindung im Substratmaterial vor der Metallisierung oberflächlich entfernt wird. Besonders bevorzugt werden dazu Vorbehandlungslösungen enthaltend Salzsäure verwendet. Das Verfahren ist insbesondere geeignet zur Erzeugung fügbarer Zinnendschichten auf Leiterplatten enthaltend Antimonverbindungen, die auf von der Lötstoppmaske nicht bedeckte Kupferanteile des Leiterbildes aufgebracht werden.

## Beschreibung

Die vorliegende Erfindung betrifft ein Verfahren zur stromlosen Abscheidung von Zinn- und Zinnlegierungsschichten auf Substraten, die Antimonverbindungen, beispielsweise als Antimontrioxid, enthalten. Das Verfahren ist insbesondere geeignet zur Erzeugung fügbarer Zinn- und Zinnlegierungsendschichten auf Leiterplatten enthaltend Antimonverbindungen, die auf von der Lötstoppmaske nicht bedeckte Kupferanteile des Leiterbildes aufgebracht werden. Unter Fügbarkeit wird hier die Bondfähigkeit oder Lötbarkeit von Oberflächen verstanden.

Antimonverbindungen dienen in diesem Zusammenhang als Flammschutzmittel und zur Verbesserung der Stanzbarkeit für die Erzeugung von Löchern.

Bei der Herstellung von Leiterplatten werden in einem der letzten Fertigungsschritte Endschichten zum Erzeugen der Fügbarkeit, auf von der Lötstoppmaske nicht bedeckte Kupferanteile des Leiterbildes aufgebracht. Die nicht von der Kupferschicht bedeckten Anteile der Leiterplatte sind insbesondere die nicht durch Leiterbahnen strukturierten Bereiche der Oberfläche. An diesen Stellen steht das Basismaterial in direktem Kontakt mit der Lösung, die für die abschließende Metallisierung beispielsweise mit Zinn verwendet wird.

Hierfür gewinnen stromlos abgeschiedene Zinn- und Zinnlegierungsschichten einen immer größer werdenden Marktanteil. Dies ist sowohl auf das robuste, zuverlässige Verfahren mit einem weiten Arbeitsfenster als auch auf die hervorragende Lötbarkeit von Zinn- und Zinnlegierungen selbst nach mehrfachen Hochtemperaturbelastungen zurückzuführen. Hierdurch ist diese Schicht einfachen organischen Schutzschichten deutlich überlegen. Darüber hinaus ist das Verfahren kostengünstiger als z.B. das Aufbringen einer Nickel-Gold-Schicht.

Unter stromlosen Abscheideverfahren werden solche verstanden, bei denen keine externe Stromquelle wie bei galvanischen Verfahren verwendet werden. In einem Reduktivbad werden die zur Abscheidung eines Metalls benötigten Elektronen vom Elektrolyten bereitgestellt. In den Bädern befinden sich Reduktionsmittel wie Natriumhypophosphit, Formaldehyd oder Borane, die in der Lage sind, Metallionen zu den entsprechenden Metallen zu reduzieren. Bei Austauschbädern werden keine Reduktionsmittel benötigt, da die gelösten Metallionen aufgrund des Potentialunterschieds in der Lage sind, direkt mit der jeweiligen Oberfläche zu reagieren. Typische Beispiele hierfür sind Gold auf Nickel und Zinn bzw. Silber auf Kupfer.

Stromlose Verfahren werden im Folgenden näher dargestellt.

Für das Aufbringen der fügbaren Zinn- und Zinnlegierungsendschicht stehen verschiedene Verfahren zur Verfügung, die an sich bekannt und im Stand der Technik beschrieben sind.

Neben reinen Zinnschichten können auch Legierungen wie beispielsweise Zinn-Silber, Zinn-Bismuth, Zinn-Blei, Zinn-Zink, Zinn-Nickel mit dem Verfahren aufgebracht werden.

Für die Oberflächenbeschichtung von Werkstücken mit Kupfer- oder Kupferlegierungen mit dem Ziel, korrosionsfeste Oberflächen zu schaffen, werden bereits seit langem Zinnendschichten in stromlosen Verfahren aufgebracht, indem sich das Grundmetall zugunsten der abgeschiedenen Zinnionen auflöst.

Zinn-Beschichtungen werden auf Oberflächen von Kupfer und von auf Kupfer basierenden Legierungen durch eine bestimmte Art des stromlosen Plattierens durch Verdrängung aufgetragen, d. h. Eintauch-Plattierungs-Techniken, wie sie im Patent US 2,891,871, im Patent US 3,303,029 und im Patent US 4,715,894 offenbart werden. In den offenbarten Zinneintauch-Plattiertechniken wird ein Bad hergestellt, das eine wässrige Lösung eines Zinn(II)-salzes, eine Säure und Thioharnstoff oder ein Thioharnstoff-Derivat als wesentliche Bestandteile enthält. In dem Zinneintauch-Plattierverfahren wird ein Gegenstand, der eine Kupfer-Oberfläche aufweist, z. B. eine Kupferplattierungs-Leiterplatte, in das Plattierungsbad während einer Zeitspanne eingetaucht, während der das Oberflächen-Kupfermetall zu Kupfer(I) oxidiert und mit dem Thioharnstoff komplexiert und an der Oberfläche durch das gleichzeitig aus dem Zinn(II)-ion reduzierte Zinnmetall ersetzt wird. Nachdem das Verdrängungsplattieren zu einer erwünschten Dicke vervollständigt ist, wird der Gegenstand aus dem Bad herausgenommen und gespült, um verbleibende Plattierungslösung zu entfernen.

Stromloses Verdrängungsplattieren wird bei der Herstellung von Leiterplatten (PCB's) und insbesondere von Mehrschichten-Leiterplatten verwendet. Leiterplatten umfassen eine nichtleitende oder dielektrische Platte, wie eine Glasfaser/Epoxyplatte, welche mit einer leitfähigen Metallschicht wie Kupfer auf einer oder beiden Oberflächen plattiert wird. Die Metallschicht auf dem PCB ist vor dem Verarbeiten typischerweise eine kontinuierliche Kupferschicht, die durch ein Muster von plattierten Durchgangslöchern oder Verbindungskontakten unterbrochen sein kann, die beide Oberflächen der Platte verbinden. Während der Verarbeitung werden ausgewählte Bereiche der Kupferschicht entfernt, um ein erhöhtes Kupferschaltungs-Bildmuster des PCB zu bilden. Mehrschichten-PCB's werden typischerweise durch Verschachtelung abgebildeter leitender Schichten, wie einer Kupfer-enthaltenden Schicht, mit dielektrischen Haftschichten, wie einem teilweise gehärteten Harz der B-Stufe, d. h. einem Prepreg, zu einem Mehrschichten-Sandwich, welches dann durch Anwendung von Wärme und Druck verbunden wird, zusammengefügt. Die Herstellung dieser Leiterplatten-Typen wird "in Printed Circuits Handbook", 3. Auflage, herausgegeben von C. F. Coombs, Jr., McGraw Hill, 1988 beschrieben. Da eine leitende Schicht mit einer glatten Kupfer-Oberfläche sich nicht gut mit dem Prepreg verbindet, sind verschiedene Behandlungen der Kupfer-Oberfläche entwickelt worden, um die Bindungsstärke zwischen den Schichten des Mehrschichten-PCB-Sandwichs zu erhöhen.

Eine derartige Behandlung der Kupfer-Oberfläche ist die Verwendung von Eintauch-Zinn und -Zinnlegierungszuammensetzungen als ein Bindungsmedium für Mehrschichten-Schaltungen wie von Holtzman et al. Im Patent US 4 175 894 offenbart wird. In dem Verfahren wird eine Eintauch-Zinn-Zusammensetzung offenbart, die sowohl Thioharnstoff-Verbindungen als auch Harnstoff-Verbindungen enthält, um die Kupfer-Oberfläche jedes PCB's mittels des Eintauch-Verfahrens durch Verdrängung mit Zinn zu plattieren, bevor sie unter Bildung einer Mehrschichten-Leiterplatte laminiert werden.

US 5,435,838 beschreibt ein Verfahren zur stromlosen Abscheidung einer Zinn-Bismuth-Legierung auf Kupferoberflächen. Bei dem Verfahren werden Zinn und Bismuth als Methansulfonate eingesetzt. Als Komplexbildner wird Thioharnstoff verwendet, um das oberflächlich gelöste Kupfer zu komplexieren.

Die beschriebenen Verfahren zur Abscheidung von Zinn- und Zinnlegierungen eignen sich jedoch nicht zur Beschichtung von Substraten, die Antimonverbindungen enthalten. Diese sind in der Industrie weit verbreitet und werden als Flammschutzmittel und zur Verbesserung der Stanzbarkeit eingesetzt, zum Beispiel bei der Produktion von Leiterplatten.

Durch diese Beschränkung ist die Anwendungsbreite von chemischen Verfahren zur Verzinnung erheblich limitiert. Ziel ist es daher, Verfahren zu finden, die sich auch für die beschriebene Substratklasse erfolgreich verwenden lassen.

Zu dieser Substratklasse enthaltend Antimonverbindungen gehören beispielsweise Leiterplatten, die als kostengünstiges Basismaterial sogenanntes CEM-1 verwenden. Dieses Material hat den Vorteil, dass das Bohren von Löchern, das einen der aufwendigsten und teuersten Schritte bei der Leiterplattenherstellung darstellt, durch einfaches Stanzen ersetzt werden kann. Bisher war es nicht möglich, CEM-1 Materialien mit stromlosen Zinnverfahren zu beschichten. Der Grund dafür ist die Verwendung von Antimonverbindungen, insbesondere Antimontrioxid, als Flammschutzmittel und zur Verbesserung der Stanzbarkeit des Basismaterials. So beschreibt z.B. die Firma Isola USA den Gehalt an Antimontrioxid in Ihrem Basismaterial 65M62 mit 5,74%. Während der Prozessschritte wird das Antimontrioxid aus dem Basismaterial an den Kanten und Stanzlöchern herausgelöst und führt zu einer Trübung und dunklen Ausfällungen in Bädern zur Abscheidung von Zinn und Zinnlegierungen. Die abgeschiedenen Zinnschichten weisen dunkle Flecken auf. Ihre Eigenschaften als fügbare Endschicht sind deswegen nicht mehr zufriedenstellend.

Die Bäder zur Abscheidung von Zinn und Zinnlegierungen sind weiterhin bereits nach der Beschichtung von wenigen Leiterplatten zur Produktion metallisierter Substrate nicht mehr einsetzbar, so dass eine kommerziell vernünftige Anwendung des Verzinnens von CEM-1 Leiterplatten nicht möglich ist.

Überraschenderweise können die beschriebenen Probleme durch eine einfache Vorbehandlung der antimonhaltigen Substratmaterialien mit einer Vorbehandlungslösung, durch die die Antimonverbindungen oberflächlich entfernt werden, gelöst werden.

Durch Anwendung des erfindungsgemäßen Verfahrens kann die störende Wirkung der im Substrat enthaltenden Antimonverbindungen so weit zurückgedrängt werden, dass die unerwünschte Ausfällung vermieden wird. Die abgeschiedenen Zinnschichten sind bei Anwendung des Verfahrens von sehr guter Qualität hinsichtlich Fügbarkeit und Haltbarkeit und die Lebensdauer des Zinnbades kann soweit verlängert werden, dass eine ökonomische Anwendung möglich wird.

Das erfindungsgemäße Verfahren wird in einer bevorzugten Ausführungsform durch die folgenden Prozessschritte charakterisiert:
1. Vorbehandlung des Substratmaterials zur oberflächlichen Entfernung von Antimonverbindungen;
2. Behandeln des Substrates mit einer Mikroätzlösung;
3. Metallisierung mit einer Zinnlösung enthaltend ein Zinn(II)-salz, Thioharnstoff und Methansulfonsäure;
4. Spülen mit Wasser.

Als Vorbehandlungslösungen für den Schritt 1. können starke Säuren wie beispielsweise Mineralsäuren (Schwefelsäure, Salpetersäure, Salzsäure) oder starke organische Säuren wie Alkansulfonsäuren, Essigsäure etc. verwendet werden.

Die Konzentration an Schwefelsäure beträgt dabei 5 - 60%, bevorzugt 10 - 30%, an Salpetersäure 5 - 40%, bevorzugt 5 - 25%. Als Alkansulfonsäure kann beispielsweise Methansulfonsäure in einer Konzentration von 5 - 70%, bevorzugt 10 - 40% verwendet werden. Statt der Säuren können auch die Salze der Säure wie Methansulfonsäure Natriumsalz oder Kaliumsalz verwendet werden.

Essigsäure kann in einer Konzentration 10 - 80%, bevorzugt 10 - 40% eingesetzt werden.

Bei der Anwendung einer besonders bevorzugten Ausführungsform des erfindungsgemäßen Verfahrens werden die zu beschichtenden Substrate mit einer salzsauren Vorbehandlungslösung behandelt. Der Gehalt an Salzsäure beträgt 5 - 38%, bevorzugt 10 - 30%, besonders bevorzugt 15 - 25% HCl.

Ebenfalls geeignet sind basische Vorbehandlungslösungen wie wässrige Lösungen von Natrium- oder Kaliumhydroxid in einer Konzentration von 10 - 400 g/l Hydroxid, bevorzugt 20 - 200 g/l Hydroxid.

Das erfindungsgemäße Verfahren wird in der Regel bei einer Temperatur im Bereich von 15 - 80°C, vorzugsweise 30 - 70°C und am meisten bevorzugt 50 - 65°C durchgeführt. In Abhängigkeit von der jeweils verwendeten Vorbehandlungslösung, insbesondere ihrer Konzentration, liegt die Behandlungsdauer im Allgemeinen im Bereich von 1 - 60 Minuten, vorzugsweise 1 - 25 Minuten und besonders bevorzugt 2 - 10 Minuten.

Bei dem Verfahren können sich die in der Vorbehandlungslösung gelösten Antimonverbindungen in Form von Antimon auf den Kupferflächen der Leiterplatte abscheiden. Gegebenfalls können diese abgeschiedenen Metallschichten mit einer Mikroätzlösung wieder entfernt werden.

Solche Mikroätzlösungen, wie sie üblicherweise zum Reinigen von Kupfer vor dem Beschichten mit Zinn oder anderen Endschichten verwendet werden, sind im Stand der Technik bekannt und bestehen in der Praxis häufig aus wässrigen Lösungen von Alkaliperoxodisulfaten oder Wasserstoffperoxid jeweils in Kombination mit Schwefelsäure. In US 6,036,758 wird eine Ätzlösung zur Oberflächenbehandlung von Kupfer beschrieben, die Wasserstoffperoxid und eine aromatische Sulfonsäure oder deren Salz enthält. Zusätzlich enthält diese Ätzlösung u.a. eine anorganische Säure, besonders bevorzugt ist Schwefelsäure. Aus EP 1 167 482 ist eine Ätz-(Polier)-Lösung bekannt, welche eine N-heterozyklische Verbindung, Wasserstoffperoxid und ein Salz der Dodecylbenzolsulfonsäure enthält.

Weiterhin können solche Mikroätzlösungen Lösungen enthaltend Schwefelsäure und Peroxodisulfat oder ihre Salze oder Caroate sein.

Die nach dem erfindungsgemäßen Verfahren vorbehandelte Leiterplatte kann dann im chemisch Zinnbad metallisiert werden, ohne dass es zu der sonst beobachteten starken Dunkeltrübung des Bades oder zu Fleckenbildung kommt. Die Zinnendschicht weist die gewünschten Eigenschaften wie hervorragende Fügbarkeit und Haltbarkeit auf.

Bei der Vorbehandlung von antimonhaltigem Substratmaterial im technischen Maßstab muss die erfindungsgemäße Vorbehandlungslösung kontinuierlich erneuert werden, da sich das in ihr gelöste Antimon anreichert und in der Folge auf den zu verzinnenden Kupferschichten abscheidet. Dies beeinflusst die Oberflächeneigenschaften der nachfolgenden Zinnendschicht negativ hinsichtlich Haltbarkeit und Fügbarkeit. Das Antimon kann zwar durch verlängerte Ätzzeiten im Mikroätzschritt wieder vom Kupfer entfernt werden. Bei hohen Antimonkonzentration in der Vorbehandlungslösung wird die Zeit für den Ätzschritt aber zu lang und beeinträchtigt die Wirtschaftlichkeit des Verfahrens.

Deshalb wird in einer erfindungsgemäßen Variante des Verfahrens vorgeschlagen, das Antimon durch Abscheidung auf einem weiteren Metall aus der Vorbehandlungslösung zu entfernen.

Dazu wird die Vorbehandlungslösung enthaltend Antimonverbindungen kontinuierlich oder diskontinuierlich über eine Kolonne geleitet, die ein Metall enthält, auf dem sich die gelöste Antimonspezies als Antimon aus der Vorbehandlungslösung abscheidet. Die Vorbehandlungslösung kann auch direkt mit dem Metall versetzt werden. Beispiele solcher Metalle umfassen Kupfer, Eisen, Nickel, Kobalt, Zinn und Zink. Das Metall kann in Form von Granalien, Stangen, Barren oder Kugeln vorliegen, auf deren Oberfläche sich das in Lösung befindliche Antimon abscheidet.

Wenn die Leistung der Kolonne dadurch erschöpft ist, dass sie eine mit Antimon vollständig bedeckte Oberfläche aufweist, kann diese nach gründlichem Spülen durch Einleiten einer Mikroätzlösung wie bereits beschrieben wieder regeneriert werden. Danach steht die Kolonne zur Regeneration der Vorbehandlungslösung wieder zur Verfügung.

Durch diese Maßnahme kann die Lebensdauer der Vorbehandlungslösung deutlich erhöht werden.

Geringe Reste von Antimon, die sich nach wie vor auf dem Substratmaterial abscheiden und im Zinnbad bei der Metallisierung lösen, können durch eine zusätzliche Maßnahme aus dem Zinnbad entfernt werden.

Hierzu wird das Zinnbad kontinuierlich oder diskontinuierlich über metallisches Zinn geleitet oder direkt mit metallischem Zinn versetzt. Dadurch scheidet sich das im Zinnbad enthaltene Antimon auf dem metallischen Zinn ab und wird so aus dem Badkreislauf entfernt.

Um eine Anreicherung des Zinnbades mit Zinnionen zu vermeiden, können im Stand der Technik bekannte Regenerationsverfahren verwendet werden. Bevorzugt wird eine in der Patentschrift DE 101 32 478 Regenerationseinheit verwendet, um die Konzentration an Zinnionen in der Lösung konstant zu halten.

Durch die beschriebenen Maßnahmen kann eine effektive chemische Metallisierung von Substratmaterialien enthaltend Antimon wie beispielsweise CEM-1 mit Zinn erfolgen. Die Lebensdauer von Bädern zur Abscheidung von Zinn und Zinnlegierungen wird stark erhöht und die Qualität der Schichten hinsichtlich Haltbarkeit und Fügefähigkeit positiv beeinflusst. Die für das erfindungsgemäße Verfahren verwendete Vorbehandlungslösung kann in einem weiteren Verfahrensschritt regeneriert werden. Dadurch wird das Abwasserproblem weitgehend gelöst und das Verfahren gewinnt zusätzlich an Wirtschaftlichkeit. Reste von Antimon, die nach wie vor im Zinnbad aus dem Substratmaterial gelöst werden und in Lösung gehen, werden durch die beschriebene Regeneration des Zinnbades über metallisches Zinn entfernt.

Die Erfindung wird durch die nachfolgenden Ausführungsbeispiele näher beschrieben.

### Ausführungsbeispiel 1:

Eine Leiterplatte aus CEM-1 Material mit den Maßen 5 x 5 cm wird bei einer Temperatur von 50°C für fünf Minuten mit einer wässrigen Lösung enthaltend 18 % Salzsäure behandelt. Danach wird das Material mit einer Mikroätzlösung "Micro Etch SF" der Firma Atotech, enthaltend im wesentlichen eine schwefelsaure Lösung von Peroxodisulfat, bei einer Temperatur von 35°C für eine Minute behandelt und dann mit Zinn metallisiert. Dazu wird ein Verfahren zur chemischen Zinnabscheidung der Firma Atotech verwendet, das die beiden folgenden Schritte umfasst:
1. Behandlung mit Stannadip F, enthaltend im wesentlichen eine saure Lösung von Zinn(II)-methansulfonat und Thioharnstoff, bei Raumtemperatur für eine Minute;
2. Behandlung mit Stannatech F, enthaltend im wesentlichen eine saure Lösung von Zinn(II)-methansulfonat und Thioharnstoff, bei einer Temperatur von 60°C für fünf Minuten.

Nach der Behandlung werden die Leiterplatten mit demineralisiertem Wasser gespült und bei einer Temperatur von 60°C getrocknet.

Die abgeschiedene Zinnschicht weist bei einer Dicke von ca. 0.5 µm eine hervorragende Haltbarkeit und sehr gute Fügeeigenschaften in Form von Lötbarkeit auf.

Der beschriebene Vorgang wird insgesamt fünfmal wiederholt. Dabei behalten die Bäder zur chemischen Metallisierung der Leiterplatten ihre ursprünglichen Eigenschaften bei. Es kommt nicht zur beschrieben Trübung und dunklen Ausfällungen im Zinnbad. Die abgeschiedenen Zinnschichten weisen keine dunklen Flecken auf und ihre Oberflächeneigenschaften bleiben erhalten.

### Ausführungsbeispiel 2:

Eine Leiterplatte aus CEM-1 Material mit den Maßen 5 x 5 cm wird bei einer Temperatur von 60°C für fünf Minuten mit einer wässrige Lösung enthaltend 10 % Salzsäure behandelt. Danach wird das Material mit einer Mikroätzlösung "Micro Etch SF" der Firma Atotech bei einer Temperatur von 35°C für eine Minute behandelt und dann mit Zinn metallisiert. Dazu wird ein Verfahren zur chemischen Zinnabscheidung der Firma Atotech verwendet, das die beiden folgenden Schritte umfasst:
1. Behandlung mit Stannadip F bei Raumtemperatur für eine Minute;
2. Behandlung mit Stannatech F bei einer Temperatur von 60°C für fünf Minuten.

Nach der Behandlung werden die Leiterplatten mit VE-Wasser gespült und bei einer Temperatur von 60°C getrocknet.

Die abgeschiedene Zinnschicht weist bei einer Dicke von ca. 0.5 µm eine hervorragende Haltbarkeit und sehr gute Fügeeigenschaften in Form von Lötbarkeit auf.

Der beschriebene Vorgang wird insgesamt fünfmal wiederholt. Dabei behalten die Bäder zur chemischen Metallisierung der Leiterplatten ihre ursprünglichen Eigenschaften bei. Es kommt nicht zur beschrieben Trübung und dunklen Ausfällungen im Zinnbad. Die abgeschiedenen Zinnschichten weisen keine dunklen Flecken auf und ihre Oberflächeneigenschaften bleiben erhalten.

Ausführungsbeispiel 3:

Die wässrige Lösung enthaltend 18 % Salzsäure zur Vorbehandlung der Leiterplatten wird gemäß Beispiel 1 verwendet. Teile der Lösung werden kontinuierlich dem Bad entnommen und über eine Kolonne aus Kupfergranulat geleitet. Dabei scheidet sich Antimon auf der Oberfläche des Granulates ab. Wenn die Kupferoberfläche weitgehend mit metallischem Antimon bedeckt ist, wird das Antimon durch Behandlung mit einer Mikroätzlösung "Micro Etch SF" der Firma Atotech gelöst, die Lösung aus der Kolonne entfernt und der Abwasserbehandlung zugeführt. Durch dieses Verfahren konnten mehr als 50 Leiterplatten mit der Salzsäurelösung behandelt werden, ohne dass die Lösung erneuert werden musste.

Die vorbehandelten Leiterplatten werden gemäß den Ausführungsbeispielen 1 oder 2 weiterbehandelt.

### Ausführungsbeispiel 4:

Teile der Stannatech F-Lösung zur Metallisierung des Substrates mit Zinn gemäß Ausführungsbeispiel 1 werden kontinuierlich dem Bad entnommen und über eine Kolonne aus Zinngranulat geleitet. Dabei scheidet sich Antimon auf der Oberfläche des Granulates ab. Wenn die Zinnoberfläche weitgehend mit metallischem Antimon bedeckt ist, wird das Antimon durch Behandlung mit einer Mikroätzlösung "Micro Etch SF" der Firma Atotech gelöst, die Lösung aus der Kolonne entfernt und der Abwasserbehandlung zugeführt.

Durch die Behandlung wird die unerwünschte Abscheidung von Antimon auf den Leiterplatten so gut wie vollständig unterbunden.

### Ausführungsbeispiel 5:

Der Stannatech F-Lösung zur Metallisierung des Substrates mit Zinn gemäß Ausführungsbeispiel 1 werden 50 g Zinngranulat zugefügt. Dabei scheidet sich Antimon auf der Oberfläche des Granulates ab. Wenn die Zinnoberfläche weitgehend mit metallischem Antimon bedeckt ist, wird das Zinngranulat aus der Metallisierungslösung entnommen und das Antimon durch Behandlung mit einer Mikroätzlösung "Micro Etch SF" der Firma Atotech gelöst, die Lösung der Abwasserbehandlung zugeführt und das von Antimon befreite Zinngranulat der Metallisierungslösung wieder zugeführt.

Durch die Behandlung wird die unerwünschte Abscheidung von Antimon auf den Leiterplatten so gut wie vollständig unterbunden.

### Ausführungsbeispiel 6:

Eine Leiterplatte aus CEM-1 Material mit den Maßen 5 x 5 cm wird bei einer Temperatur von 55°C für fünf Minuten mit einer wässrige Lösung enthaltend 20% Natriumhydroxid behandelt. Danach wird das Material mit einer Mikroätzlösung "Micro Etch SF" der Firma Atotech bei einer Temperatur von 35°C für eine Minute behandelt und dann mit Zinn metallisiert. Dazu wird ein Verfahren zur chemischen Zinnabscheidung der Firma Atotech verwendet, das die beiden folgenden Schritte umfasst:
3. Behandlung mit Stannadip F, bei Raumtemperatur für eine Minute;
4. Behandlung mit Stannatech F bei einer Temperatur von 60°C für fünf Minuten.

Nach der Behandlung werden die Leiterplatten mit VE-Wasser gespült und bei einer Temperatur von 60°C getrocknet.

Die abgeschiedene Zinnschicht weist bei einer Dicke von ca. 0.5 µm eine hervorragende Haltbarkeit und sehr gute Fügeeigenschaften in Form von Lötbarkeit auf.

Der beschriebene Vorgang wird insgesamt viermal wiederholt. Dabei behalten die Bäder zur chemischen Metallisierung der Leiterplatten ihre ursprünglichen Eigenschaften bei. Es kommt nicht zur beschrieben Trübung und dunklen Ausfällungen im Zinnbad. Die abgeschiedenen Zinnschichten weisen keine dunklen Flecken auf und ihre Oberflächeneigenschaften bleiben erhalten.

### Vergleichsbeispiele

### Vergleichsbeispiel 1:

Eine Leiterplatte aus CEM-1 Material mit den Maßen 5 x 5 cm wird bei einer Temperatur von 40°C für fünf Minuten mit dem Reiniger Pro Select SF der Firma Atotech, wie er bei der konventionellen Metallisierung von Leiterplatten standardmäßig eingesetzt wird, behandelt. Danach wird das Material mit einer Mikroätzlösung "Micro Etch SF" der Firma Atotech bei einer Temperatur von 35°C für eine Minute behandelt und dann mit Zinn metallisiert. Dazu wird ein Verfahren zur chemischen Zinnabscheidung der Firma Atotech verwendet, das die beiden folgenden Schritte umfasst:
1. Behandlung mit Stannadip F bei Raumtemperatur für eine Minute;
2. Behandlung mit Stannatech F bei einer Temperatur von 60°C für fünf Minuten.

Nach der Behandlung werden die Leiterplatten mit VE-Wasser gespült und bei einer Temperatur von 60°C getrocknet.

Die abgeschiedene Zinnschicht weist bei einer Dicke von ca. 0.5 µm zunächst eine zumindest zufriedenstellende Fügbarkeit auf.

Bereits beim nächsten Metallisierungsschritt verliert das Stannatech-Bad seine ursprünglichen Eigenschaften. Es kommt zur Trübung und Bildung von dunklen Ausfällungen im Zinnbad. Die abgeschiedene Zinnschicht weist dunklen Flecken auf und verliert ihre gewünschten Oberflächeneigenschaften. Die Eigenschaften des Zinnbades verschlechtern sich nachfolgend rapide. Bereits nach dem vierten Schritt ist die Metallisierung unvollständig und das Bad kann nicht mehr verwendet werden.

### Vergleichsbeispiel 2:

Eine Leiterplatte aus CEM-1 Material mit den Maßen 5 x 5 cm wird ohne Vorbehandlung mit einer Mikroätzlösung "Micro Etch SF" der Firma Atotech bei einer Temperatur von 35°C für eine Minute behandelt und dann mit Zinn metallisiert. Dazu wird ein Verfahren zur chemischen Zinnabscheidung der Firma Atotech verwendet, das die beiden folgenden Schritte umfasst:
1. Behandlung mit Stannadip F bei Raumtemperatur für eine Minute;
2. Behandlung mit Stannatech F bei einer Temperatur von 60°C für fünf Minuten.

Nach der Behandlung werden die Leiterplatten mit VE-Wasser gespült und bei einer Temperatur von 60°C getrocknet.

Die abgeschiedene Zinnschicht weist bei einer Dicke von ca. 0.5 µm zunächst eine zumindest zufriedenstellende Fügbarkeit auf.

Bereits beim nächsten Metallisierungsschritt verliert jedoch das Stannatech Bad seine ursprünglichen Eigenschaften. Es kommt zur Trübung und Bildung von dunklen Ausfällungen im Zinnbad. Die abgeschiedene Zinnschicht weist dunklen Flecken auf und verliert ihre gewünschten Oberflächeneigenschaften. Die Eigenschaften des Zinnbades verschlechtern sich nachfolgend rapide. Bereits nach wenigen Verfahrensschritten ist die Metallisierung unvollständig. Das Bad muß verworfen werden.

## Patentansprüche

1. Verfahren zur stromlosen Metallisierung von Substratmaterialien enthaltend Antimonverbindungen mit Zinn oder Zinnlegierungen **dadurch gekennzeichnet, dass** die Antimonverbindung im Substratmaterial vor der Metallisierung oberflächlich entfernt wird.

2. Verfahren nach Anspruch 1 **dadurch gekennzeichnet, dass** die Antimonverbindung im Substratmaterial vor der Metallisierung durch eine Lösung enthaltend eine Mineralsäure ausgewählt aus der Gruppe umfassend Salzsäure, Schwefelsäure und Salpetersäure oberflächlich entfernt wird.

3. Verfahren nach einem der vorstehenden Ansprüche **dadurch gekennzeichnet, dass** die Antimonverbindung im Substratmaterial vor der Metallisierung durch eine Lösung enthaltend Salzsäure in einer Konzentration von 5 - 38%, bevorzugt 10 - 30%, besonders bevorzugt 15 - 25% Salzsäure oberflächlich entfernt wird.

4. Verfahren nach einem der vorstehenden Ansprüche **dadurch gekennzeichnet, dass** die in der Vorbehandlungslösung gelösten Antimonverbindungen durch Abscheidung in einer chemischen Austauschreaktion gegen ein Metall aus der Lösung entfernt werden.

5. Verfahren nach Anspruch 4 **dadurch gekennzeichnet, dass** zur Abscheidung des Antimons in einer chemischen Austauschreaktion die Lösung entweder kontinuierlich oder diskontinuierlich über eine Kolonne mit einem Metall geleitet wird.

6. Verfahren nach Anspruch 4 **dadurch gekennzeichnet, dass** zur Abscheidung des Antimons in einer chemischen Austauschreaktion die Vorbehandlungslösung direkt mit einem Metall versetzt wird.

7. Verfahren nach einem der Ansprüche 4 - 6 **dadurch gekennzeichnet, dass** das Metall zur Abscheidung des Antimons in einer chemischen Austauschreaktion in Form von Granalien, Stangen, Barren oder Kugeln verwendet wird.

8. Verfahren nach einem der Ansprüche 4 - 7, **dadurch gekennzeichnet, dass** das Metall zur Abscheidung des Antimons in einer chemischen Austauschreaktion ausgewählt ist aus der Gruppe umfassend Kupfer, Eisen, Nickel, Kobalt, Zinn und Zink.

9. Verfahren nach einem der vorstehenden Ansprüche 4 - 8 **dadurch gekennzeichnet, dass** die Antimonschicht, die sich in einer chemischen Austauschreaktion auf einem Metall gebildet hat, durch Behandeln mit einer Mikroätzlösung wieder entfernt wird.

10. Verfahren nach einem der vorstehenden Ansprüche **dadurch gekennzeichnet, dass** die in der für die Metallisierung mit Zinn oder Zinnlegierungen verwendete Lösung enthaltenen Antimonverbindungen durch Abscheidung in einer chemischen Austauschreaktion gegen metallisches Zinn aus der Lösung entfernt werden.

11. Verfahren nach Anspruch 10 **dadurch gekennzeichnet, dass** zur Abscheidung des Antimons in einer chemischen Austauschreaktion die Lösung entweder kontinuierlich oder diskontinuierlich über eine Kolonne mit metallischem Zinn geleitet wird.

12. Verfahren nach einem der Ansprüche 10 - 11 **dadurch gekennzeichnet, dass** die Antimonschicht, die sich auf dem Zinn in einer chemischen Austauschreaktion gebildet hat, durch Behandeln mit einer Mikroätzlösung wieder entfernt wird.

13. Verfahren nach einem der vorstehenden Ansprüche **dadurch gekennzeichnet, dass** die Zinn- oder Zinnlegierungsbeschichtung aus einer Metallisierungslösung enthaltend Zinn(II)-methansulfonat als Zinnquelle erfolgt.

14. Verfahren nach einem der vorstehenden Ansprüche **dadurch gekennzeichnet, dass** die Zinn- oder Zinnlegierungsbeschichtung aus einer Metallisierungslösung enthaltend Thioharnstoff erfolgt.

15. Anwendung des Verfahrens nach einem der vorstehenden Ansprüche **dadurch gekennzeichnet, dass** die Zinn- oder Zinnlegierungsbeschichtung zur Erzeugung fügbarer Schichten erfolgt.

16. Anwendung des Verfahrens nach einem der vorstehenden Ansprüche bei der Produktion von elektrischen Schaltungsträgern oder in der Halbleitertechnik in Vertikal- und/oder Horizontalanlagen.

17. Anwendung des Verfahrens nach einem der vorstehenden Ansprüche, **dadurch gekennzeichnet, dass** die elektrischen Schaltungsträger Leiterplatten sind.

18. Elektrische Schaltungsträger enthaltend Antimonverbindungen im Substratmaterial mit einer stromlos aufgebrachten Zinn- oder Zinnlegierungsschicht zur Erzeugung fügbarer Schichten.

19. Leiterplatten enthaltend Antimonverbindungen im Substratmaterial mit einer stromlos aufgebrachten Zinn- oder Zinnlegierungsschicht zur Erzeugung fügbarer Schichten.
